# EUROPEAN PATENT SPECIFICATION

(11) **EP 3 024 034 B1**
(45) Date of publication and mention of the grant of the patent: **06.05.2020**
(21) Application number: 14198214.0
(22) Date of filing: 16.12.2014
(51) Int. Cl.: H01L 27/02, H01L 29/74

(54) **ESD PROTECTION SEMICONDUCTOR DEVICE**
HALBLEITER-ESD-SCHUTZVORRICHTUNG
DISPOSITIF SEMI-CONDUCTEUR DE PROTECTION ESD

(30) Priority: 20.11.2014 US 201414548298
(43) Date of publication of application: 25.05.2016
(73) Proprietor: MediaTek Inc., Hsin-Chu 300 (TW)
(72) Inventor: Huang, Bo-Shih, Hsinchu City 300 (TW); Chuang, Chien-Hui, 231 New Taipei City (TW); Hung, Cheng-Chou, 303 Hsinchu County (TW)
(74) Representative: Hoefer & Partner Patentanwälte mbB

(56) References cited:
- KR-B1- 100 942 701
- US-A1- 2003 042 498
- US-A1- 2005 173 727
- US-A1- 2005 270 710
- US-A1- 2007 262 386
- US-A1- 2010 301 418

## Description

### Background

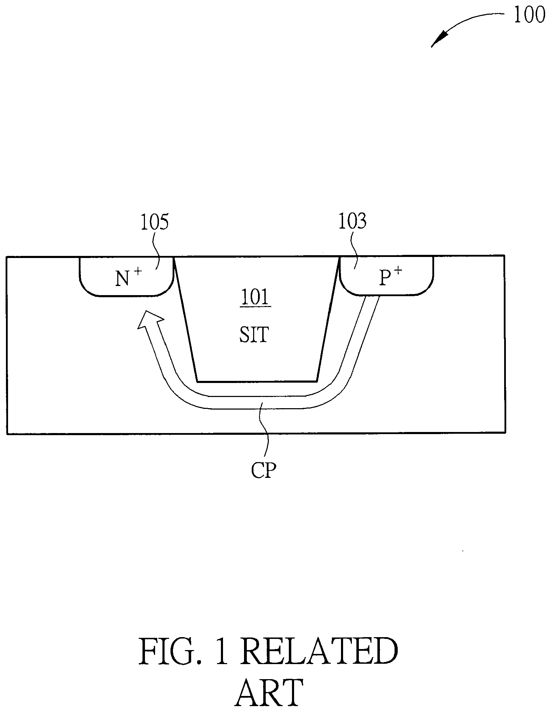

Conventionally, at least one STI (shallow trench insulator)is provided between a P doped region and an N doped region to separate the P doped region and the N doped region. FIG.1 is a semiconductor device 100 with a STI 101 for related art. As shown in FIG.1, a STI 101 is provided between a P doped region 103 and an N doped region 105. Therefore, a current path CP for transmitting currents from the P doped region 103 to the N doped region 105 must by-pass the STI 101 since materials of the STI 101 are not conductive. In such case, the current path CP is longer, such that the charge/discharge time for the semiconductor device is correspondingly extended, which may causes some disadvantages. For example, if the semiconductor device 100 is applied as an ESD device, the circuit protected by such device is easily broken since the semiconductor device 100 has a low discharge speed.

Prior art document US 2005/0173727 A1 discloses an ESD protection circuit which is formed at an input/output interface contact of an integrated circuit to protect the integrated circuit from damage caused by an ESD event. The ESD protection circuit has a polysilicon bounded SCR connected between a signal input/output interface contact of the integrated circuit and a power supply connection of the integrated circuit and a biasing circuit. The biasing circuit is connected to the polysilicon bounded SCR to bias the polysilicon bounded SCR to turn on more rapidly during the ESD event. The biasing circuit is formed by at least one polysilicon bounded diode and a first resistance.

Document US 2010 0301418 A1 describes an electrostatic discharge protection device that overcomes problems of an LVTNR device by serially connecting a diode to the LVTNR device and coupling a gate of a MOSFET structure thereto. The electrostatic discharge protection device of the present invention includes a diode comprising N well / P⁺ diffusion regions; a resistor connected in parallel to the diode; a MOS transistor having a drain connected to the diode and the resistor and constituting a cathode along with a source and a gate; and at least one diode connected in series to the cathode.

Prior art document US 2007 0262386 A1 refers to an ESD protection element for use in an electrical circuit having a fin structure or a fully depleted silicon-on-insulator structure. The fin structure or the fully depleted silicon-on-insulator structure contain a first connection region having a first conductivity type; a second connection region having a second conductivity type, which is opposite to the first conductivity type; and also a plurality of body regions which are formed alongside one another and which are formed between the first connection region and the second connection region. The body regions alternately have the first conductivity type and the second conductivity type. The ESD protection element has at least one gate region formed on or above at least one of the plurality of body regions, and also at least one gate control device which is electrically coupled to the at least one gate region.

Document US 2005 0270710 A1 defines a silicon controlled rectifier (SCR) for electrostatic discharge (ESD) protection comprising two terminal electrodes of a first electrode and a second electrode, a PMOS, an NMOS and an SCR structure. By utilizing an embedded SCR, a whole-chip ESD protection circuit design can be obtained.

Prior art document US 2003 0042498 A1 shows P_STSCR structure which includes a P-type substrate, an N-well in the P-type substrate, a first N⁺ diffusion region located in the P-type substrate connected to the cathode, a second P⁺ diffusion region located in the N-well connected to the anode, and a third P⁺ diffusion region as a trigger node located in the P-type substrate and between the first N⁺ diffusion region and the second P⁺ diffusion region. A lateral SCR device including the second P⁺ diffusion region, the N-well, the P-type substrate and the first N⁺ diffusion region is thereby formed.

Document KR 100 942 701 B1 discloses an ESD protection element which is provided to form a protection circuit satisfactory for various ESD performance indexes by forming a CMOS structure in a SCR structure in order to form a new structure thereof. A drain terminal of a PMOS field effect transistor is connected to an anode terminal formed on a semiconductor substrate. A source terminal of a first NMOS field effect transistor is connected to a cathode terminal formed on the semiconductor substrate. A plurality of RC networks is connected to a gate terminal of the PMOSFET and a gate terminal of the NMOSFET, respectively in order to apply biases. A source terminal of the PMOSFET is connected with a drain terminal through a metal.

### Summary

It is an objective of the present application is to provide a semiconductor device that can provide higher discharging speed.

The object underlying the present invention is achieved by a semiconductor device according to independent claim 1. Preferred embodiments are defined in the respective dependent claims.

In some embodiments, the first type is N type and the second type is P type. In other embodiments, the first type is P type and the second type is N type.

These and other objectives of the present invention will no doubt become obvious to those of ordinary skill in the art after reading the following detailed description of the preferred embodiment that is illustrated in the various figures and drawings.

### Brief Description of the Drawings

FIG.1 is a semiconductor device with a STI for related art.
FIG.2 to FIG.7 are top views and cross-sectional views for semiconductor devices, without silicide.
FIG.8 to FIG.10 are cross-sectional views for semiconductor devices, with silicide.
FIG.11 is a circuit diagram illustrating a voltage providing circuit for providing voltages to the semiconductor devices disclosed in the present application.

### Detailed Description

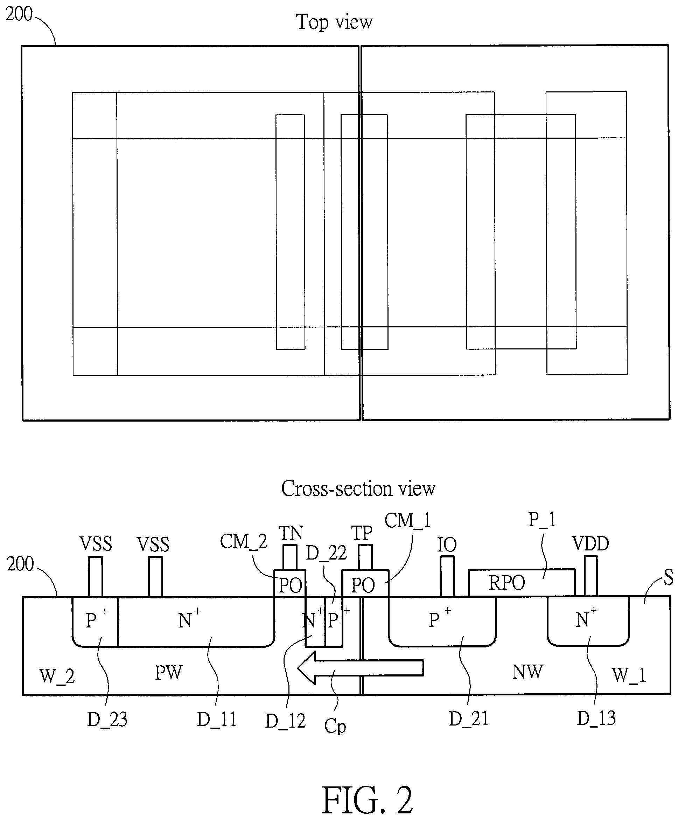

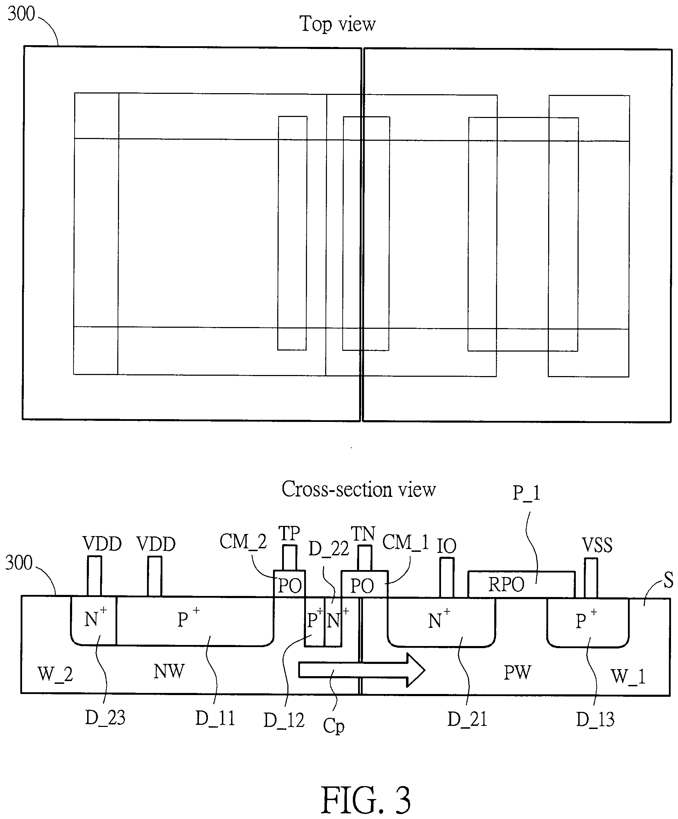

FIG.2 to FIG.7 are top views and cross-sectional views for semiconductor devices. For the brevity of illustrating, a first type and a second type are applied to respectively indicate the N type or the P type. However, the first type and the second type indicate different meanings. In FIG.2, FIG.4, FIG.6, FIG.8 (a), FIG.9 (a), FIG.10(a), the first type indicates the N type, the second type indicates the P type. On the contrary, in FIG.3, FIG.5, FIG.7, FIG.8(b), FIG.9(b), FIG.10(b), the first type indicates the P type, the second type indicates the N type.

Please refer to FIG.2, the semiconductor device 200 comprises a substrate S. The substrate S comprises: a well of type one W_1 ; a first doped region of type two D_21, provided in the well of type one W_1; a well of type two W_2, adjacent to the well of type one W_1; and a first doped region of type one D_11, doped in the well of type two W_2. The substrate S comprises no isolating material, such as above-mentioned STI, provided in a current path CP formed by the first doped region of type two D_21, the well of type one W_1, the well of type two W_2 and the first doped region of type one D_11. In this embodiment, the current path CP is from IO to the VSS provided to the first doped region of type one D_11.

In the embodiment of FIG.2, the semiconductor device 200 further comprises a first conductive material CM_1 and a second conductive CM_2 (ex. poly silicide). The first conductive material CM_1 is provided on the well of type one W_1 and the well of type two W_2 but not on the first doped region of type one D_11 and the first doped region of type two D_21. Additionally, the second conductive layer CM_2 is provided on the well of type two W_2 but not on the first doped region of type one D_11. The first conductive material CM_1 and the second conductive CM_2 can receive different voltages TP, TN to assist the transmission of currents.

Moreover, the semiconductor device 200 comprises a second doped region of type one D_12 provided in the well of type two; and a second doped region of type two D_22 provided in the well of type two W_1. The second doped region of type one D_12 and the second doped region of type two D_22 can assist the transmitting of currents. The second doped region of type two D_22 and the second doped region of type one D_12 are provided between the first doped region of type one D_11 and the first doped region of type two D_21. In such case, the first conductive material CM_1 is provided on a region between the first doped region of type two D_21 and the second doped region of type two D_22. The second conductive material CM_2 is provided on a region between the first doped region of type one D_11 and the second doped region of type one D_12.

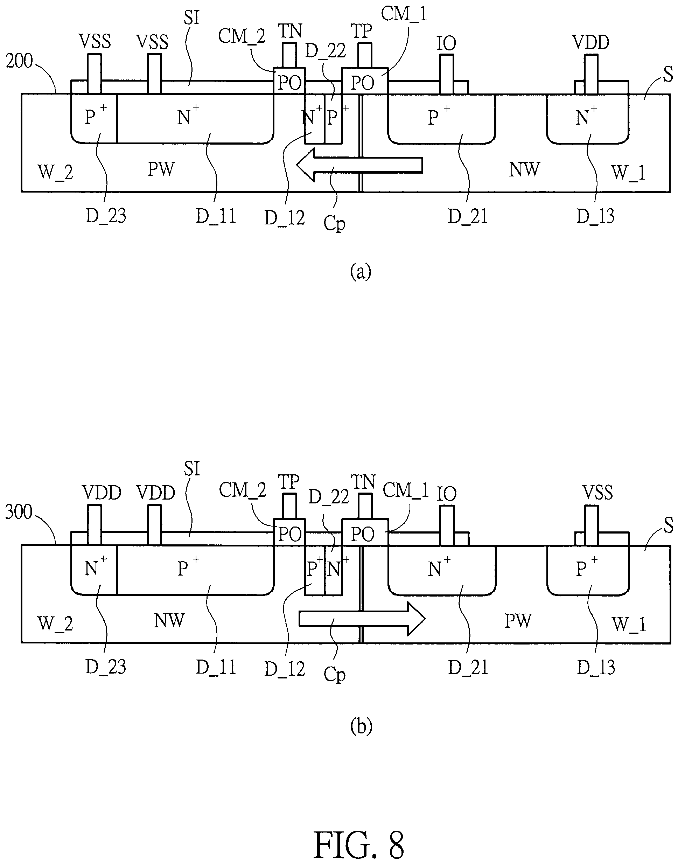

Please note during the process of manufacturing of the semiconductor device 200, a protecting material P_1 can be provided as shown in FIG.2. By this way, the silicide is not generated at the location of the protecting material P_1. Please refer to FIG.8(a), which illustrates an similar to the structure shown in FIG.2 further comprising silicide SI. As shown in FIG.8 (a), the silicide SI is not generated at the location of the protecting material P_1 shown in FIG.2. For more detail, in FIG.8(a) the silicide SI is not provided on at least part of the well of type one W_1 adjacent to the first doped region of type two D_21, and at least part of the first doped region of type two D_21 adjacent to the well of type one W_1.

Besides, the semiconductor device 200 in FIG.2 further comprises: a third doped region of type one D_13, doped in the well of type one W_1, not touching the first doped region of type two D_21 ; and a third doped region of type two D_23, doped in the well of type two W_2, touching the first doped region of type one D_11. The protecting material P_1 covers part of the third doped region of type one D_13. Therefore, in FIG. 8 (a), no silicide is provided on at least part of the well of type one W_1 adjacent to the third doped region of type one D_13, and at least part of the third doped region of type one D_13 adjacent to the well of type one W_1. The third doped region of type one D_13 is coupled to an operational voltage VDD and the third doped region of type two D_23 is coupled to another operational voltage VSS.

For the embodiment shown in FIG.3, the semiconductor device 300 comprises a similar structure as that of the semiconductor device 200. One of the differences is that the first type is changed from the N type to the P type, and the second type is changed from the P type to the N type in FIG.3. Additionally, the operational voltages VDD, VSS are swapped. Furthermore, current path CP is inverted from the VDD provided to the first doped region of type one D_11 to IO. Moreover, the voltages TP, TN are swapped. FIG.8 (b) illustrates the situation wherein the semiconductor device 300 comprises silicide SI. Other structures and operations for the semiconductor device 300 can be clearly understood based on the description for FIG.2, thus it is omitted for brevity here.

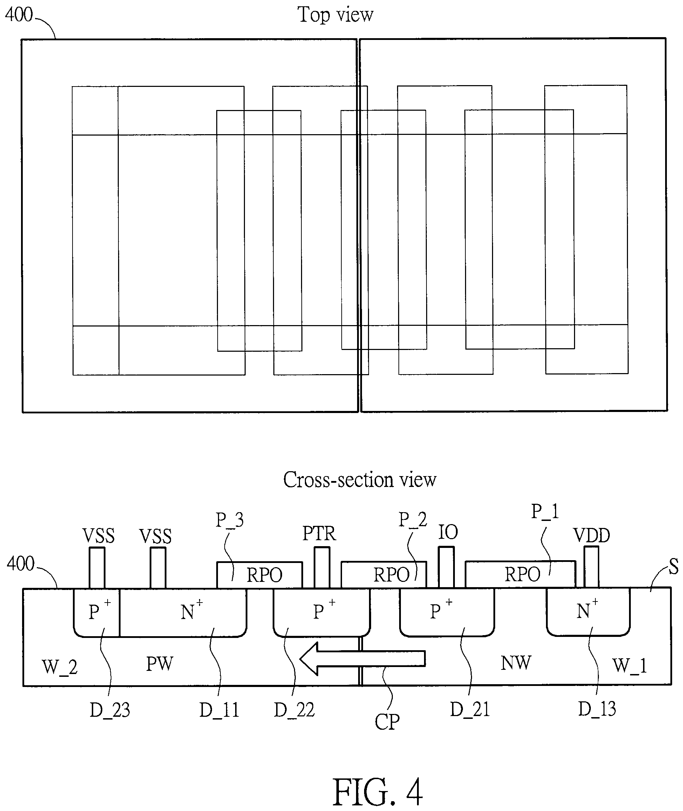

The substrate S in the semiconductor device 400 in FIG.4 also comprises the well of type one W_1, the first doped region of type two D_21, the well of type two W_2, the first doped region of type one D_11, the third doped region of type one D_31 and the second doped region of type one D_32. However, the semiconductor device 400 comprises only the second doped region of type two D_22 rather than the first conductive material CM_1, the second conductive material CM_2 , the second doped region of type one D_21 and the second doped region of type two D_22 in FIG.2. In the semiconductor device 400, the second doped region of type two D_22 does not touch the first doped region of type one D_11 and the first doped region of type two D_21. Additionally, the second doped region of type two D_22 in FIG.4 receives a voltage PTR to assist transmitting the current.

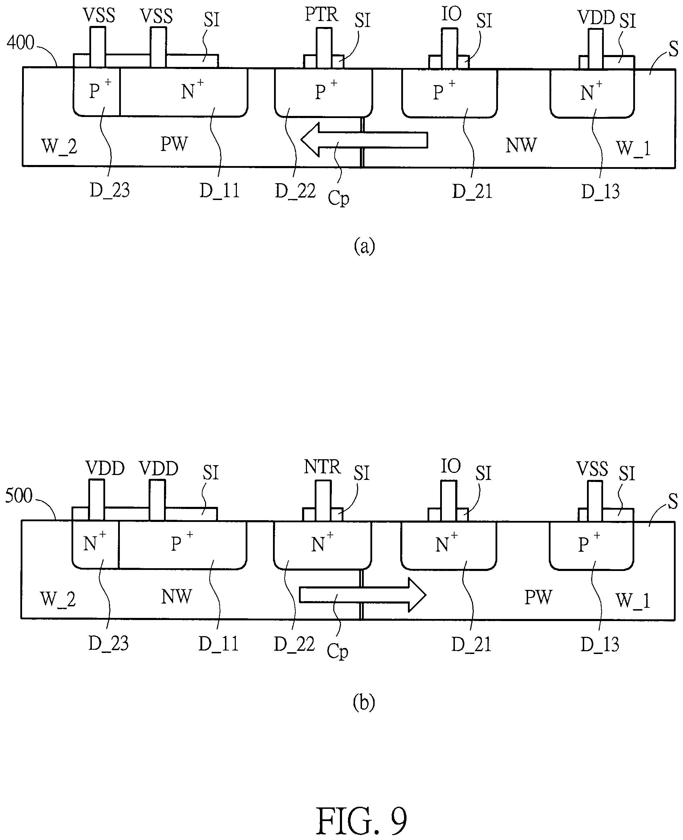

During the manufacturing of the semiconductor device 400, the semiconductor device 400 also comprises protecting material P_1. Besides, the semiconductor device 400 further comprises the protecting material P_2 and the protecting material P_3. The protecting material P_2 is provided on at least part of the first doped region of type two D_21, at least part of the second doped region of type two D_22, and at least part of the well of type one W_1 between the first doped region of type two D_21 and the second doped region of type two D_22. The protecting material P_3 is provided on at least part of the first doped region of type one D_11, at least part of the second doped region of type two D_22, and at least part of the well of type two between the first doped region of type one D_11 and the second doped region of type two D_22. Therefore, the silicide SI is not provided at the locations for the protecting materials P_1, P_2 and P_3, as shown in FIG.9(a).

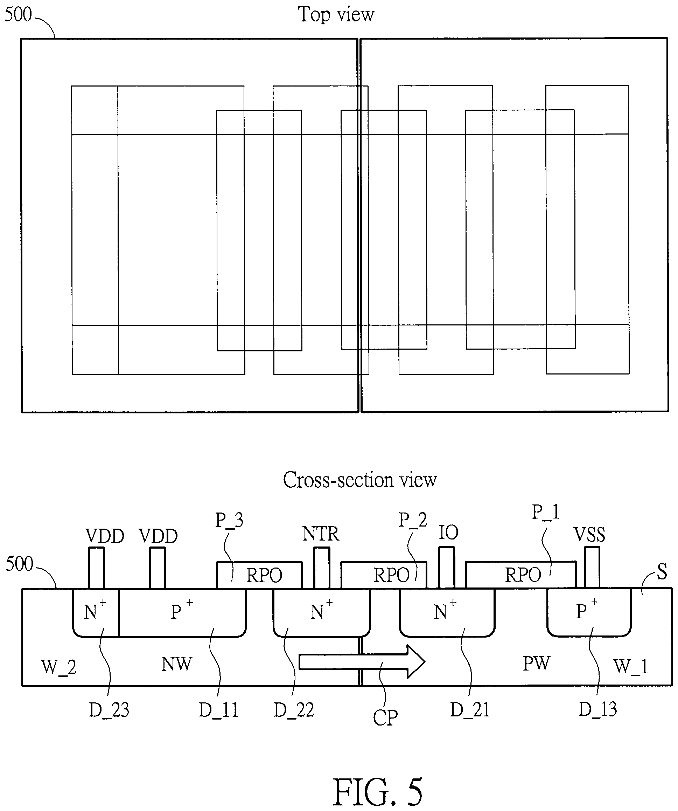

The semiconductor device 500 in FIG.5 comprises similar structure as that of the semiconductor device 400. One of the differences is that the first type is changed from the N type to the P type, and the second type is changed from the P type to the N type in FIG. 5. Additionally, the operational voltages VDD, VSS are swapped. Furthermore, current path CP is inverted from the VDD provided to the first doped region of type one D_11 to IO. FIG.9(b) illustrates the situation that the semiconductor device 500 comprises silicide SI. Other structures and operations for the semiconductor device 500 can be clearly understood based on the description for FIG.4, thus it is omitted for brevity here.

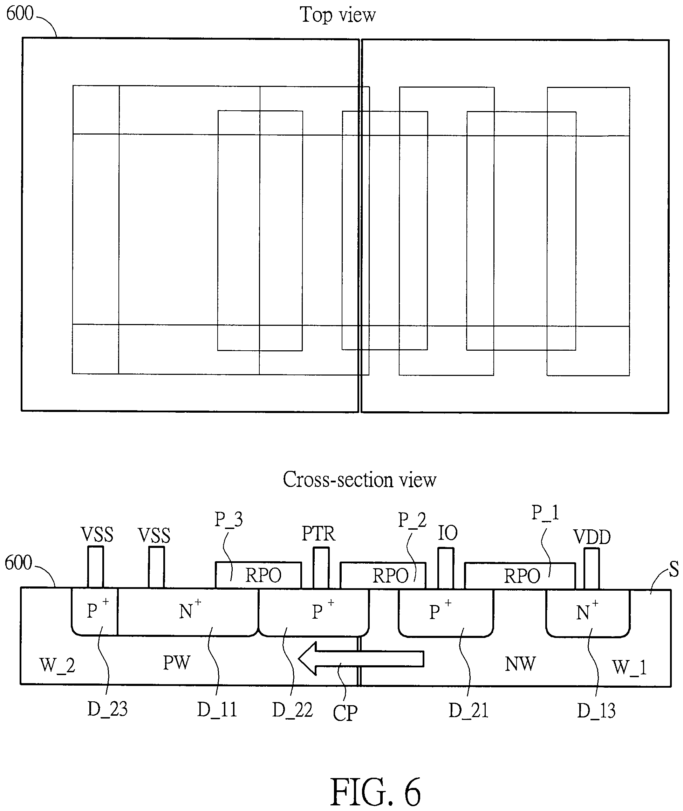

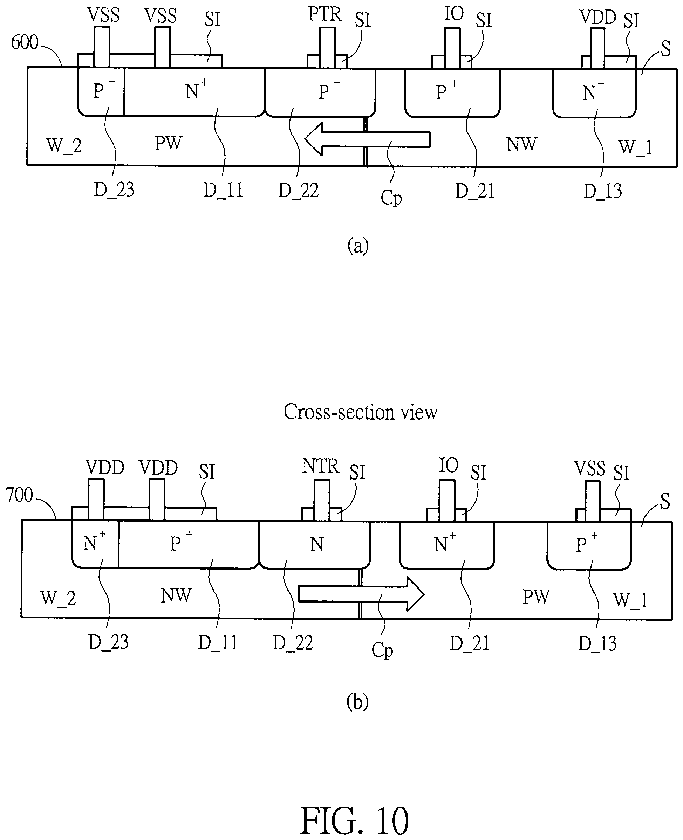

FIG.6 is a schematic diagram illustrating a semiconductor device 600 according to another example not forming part of the claimed invention but useful for understanding it. The only difference between the examples in FIG.4 and FIG.6 is that the second doped region of type two D_22 does not touch the first doped region of type one D_11 in FIG.4 , but the second doped region of type two D_22 touches (or overlaps) the first doped region of type one D_11 in FIG.6. Therefore, the protecting material P_3 in FIG.6 is provided on at least part of the first doped region of type one D_11, and at least part of the second doped region of type two D_22. The silicide SI is not provided at the locations for the protecting materials P_1, P_2 and P_3 of FIG.6, as shown in FIG.10(a).

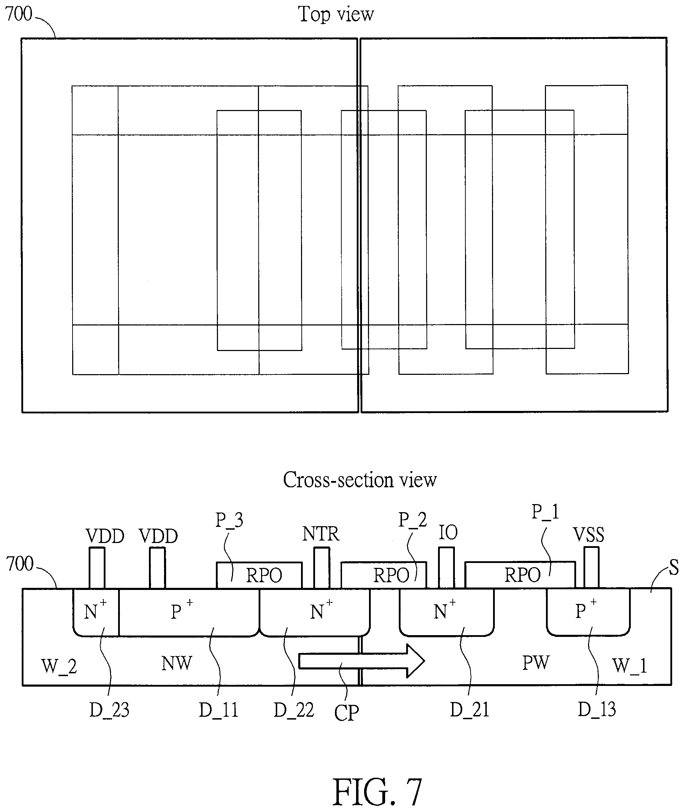

The semiconductor device 700 in FIG.7 comprises similar structure of that of the semiconductor device 600. One of the differences is that the first type is changed from the N type to the P type, and the second type is changed from the P type to the N type in FIG. 6. Additionally, the operational voltages VDD, VSS are swapped. Furthermore, current path CP is inverted from the VDD provided to the first doped region of type one D_11 to IO. FIG. 10 (b) illustrates the situation wherein the semiconductor device 700 comprises silicide. Other structures and operations for the semiconductor device 700 can be clearly understood based on the description for FIG.6, thus it is omitted for brevity here.

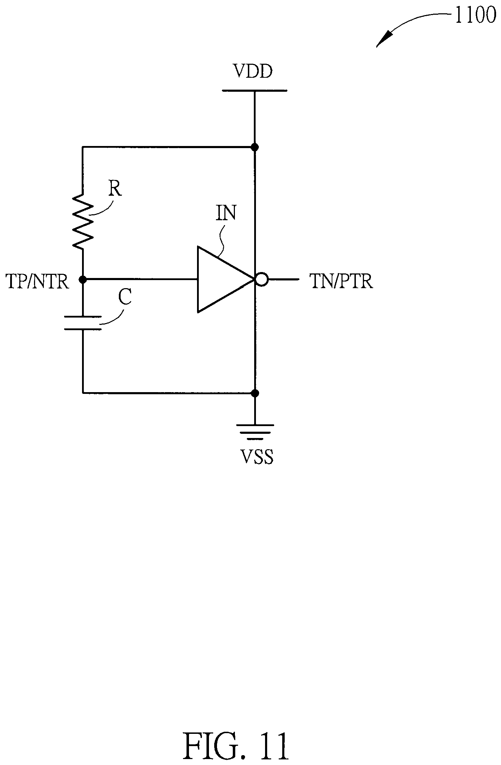

The voltages TP, TN in FIG.2 and FIG.3, and the voltages PTR,NTR in FIG.4-FIG.7, are applied for assisting the transmitting of the currents, as above-mentioned. The values thereof depend on the types of channels for the current path. In the devices of FIG.2-FIG.7, the voltage TN is higher than the voltage TP, and the voltage PTR is higher than the voltage NTR. FIG.11 is a circuit diagram illustrating a voltage providing circuit 1100 for providing voltages to the semiconductor devices disclosed in the present application. As shown in FIG.11, the voltage providing circuit 1100 is a RC inverter. A higher voltage, such as TN or PTR can be derived from the output of the voltage providing circuit 1100, and a lower voltage, such as TP or NTR, can be derived from the input of the voltage providing circuit 1100. Please note the circuit for providing the voltages TP, TN, PTR, NTR are not limited to the circuit structure shown in FIG.11.

In view of the above-mentioned embodiments and examples not forming part of the present invention but useful for its understanding, no STI is provided between P doped region and the N doped region, thus the current path is shorter and the discharging time for the semiconductor device is reduced. Also, voltage assisting the current transmitting can be provided to the semiconductor device. By this way, the circuit need to be protected can be well protected if the disclosed semiconductor device is applied as an ESD device.

## Claims

1. A semiconductor device (200, 300) applied as an ESD device comprising:
a substrate (S), comprising:
- a well (W_1) of type one;
- a first doped region (D_21) of type two, provided in the well (W_1) of type one;
- a well (W_2) of type two, adjacent to the well (W_1) of type one;
- a first doped region (D 11) of type one, doped in the well (W_2) of type two;
- a third doped region (D_13) of type one, doped in the well (W_1) of type one, not physically touching the first doped region (D_21) of type two; and
- a third doped region (D_23) of type two, doped in the well (W_2) of type two, physically touching the first doped region (D_11) of type one,
such that the substrate (S) does not comprise isolating material provided in a current path (Cp) formed by the first doped region (D_21) of type two, the well (W_1) of type one, the well (W_2) of type two and the first doped region (D_11) of type one, and further comprising:
- a first conductive material (CM_1), provided on the well (W_1) of type one and the well (W_2) of type two but not on the first doped region (D_11) of type one and the first doped region (D_21) of type two;
- a second conductive layer (CM_2), provided on the well (W_2) of type two but not on the first doped region (D_11) of type one;
- a second doped region (D_12) of type one, provided in the well (W_2) of type two; and
- a second doped region (D_22) of type two, provided in the well (W_2) of type two;
wherein:
- the second doped region (D_22) of type two and the second doped region (D_12) of type one are provided between the first doped region (D_11) of type one and the first doped region (D_21) of type two;
- wherein the first conductive material (CM_1) is provided on a region between the first doped region (D_21) of type two and the second doped region of type two (D_22); and
- wherein the second conductive material (CM_2) is provided on a region between the first doped region (D_11) of type one and the second doped region (D_12) of type one.

2. The semiconductor device (200, 300) of claim 1, which is configured such that no silicide is provided on at least part of the well (W_1) of type one adjacent to the first doped region (D_21) of type two, and at least part of the first doped region (D_21) of type two adjacent to the well (W_1) of type one.

3. The semiconductor device (200, 300) of claim 1, wherein the type one is N type and the type two is P type.

4. The semiconductor device (200, 300) of claim 1, wherein the type one is P type and the type two is N type.

5. The semiconductor device (200, 300) of claim 1, which is configured such that no silicide is provided on at least part of the well (W_1) of type one adjacent to the third doped region (D_13) of type one, and at least part of the third doped region (D_13) of type one adjacent to the well (W_1) of type one.

## Patentansprüche

1. Halbleitervorrichtung (200, 300), die in einer ESD-Vorrichtung eingesetzt wird, aufweisend:
ein Substrat (S), aufweisend:
- eine Wanne (W_1) eines Typs eins;
- einen ersten dotierten Bereich (D_21) eines Typs zwei, der in der Wanne (W_1) des Typs eins vorgesehen ist;
- eine Wanne (W_2) des Typs zwei angrenzend an die Wanne (W_1) des Typs eins;
- einen ersten dotierten Bereich (D_11) des Typs eins, dotiert in der Wanne (W_2) des Typs zwei;
- einen dritten dotierten Bereich (D_13) des Typs eins, dotiert in der Wanne (W_1) des Typs eins, der den ersten dotierten Bereich (D_21) des Typs zwei nicht physikalisch berührt; und
- einen dritten dotierten Bereich (D_23) des Typs zwei, dotiert in der Wanne (W_2) des Typs zwei, der den ersten dotierten Bereich (D_11) des Typs eins physikalisch berührt,
sodass das Substrat (S) kein isolierendes Material aufweist, das in einem Strompfad (Cp) vorgesehen ist, der durch den ersten dotierten Bereich (D_21) des Typs zwei, die Wanne (W_1) des Typs eins, die Wanne (W_2) des Typs zwei und den ersten dotierten Bereich (D_11) des Typs eins ausgebildet wird, und weiter aufweisend:
- ein erstes leitfähiges Material (CM_1), das auf der Wanne (W_1) des Typs eins und der Wanne (W_2) des Typs zwei aber nicht auf dem ersten dotierten Bereich (D_11) des Typs eins und dem ersten dotierten Bereich (D_21) des Typs zwei vorgesehen ist;
- eine zweite leitfähige Schicht (CM_2), die auf der Wanne (W_2) des Typs zwei aber nicht auf dem ersten dotierten Bereich (D_11) des Typs eins vorgesehen ist;
- einen zweiten dotierten Bereich (D_12) des Typs eins, der in der Wanne (W_2) des Typs zwei vorgesehen ist; und
- einen zweiten dotierten Bereich (D_22) des Typs zwei, der in der Wanne (W_2) des Typs zwei vorgesehen ist;
wobei:
- der zweite dotierte Bereich (D_22) des Typs zwei und der zweite dotierte Bereich (D_12) des Typs eins zwischen dem ersten dotierten Bereich (D_11) des Typs eins und dem ersten dotierten Bereich (D_21) des Typs zwei vorgesehen sind;
- wobei das erste leitfähige Material (CM_1) auf einem Bereich zwischen dem ersten dotierten Bereich (D_21) des Typs zwei und dem zweiten dotierten Bereich des Typs zwei (D_22) vorgesehen ist; und
- wobei das zweite leitfähige Material (CM_2) auf einem Bereich zwischen dem ersten dotierten Bereich (D_11) des Typs eins und dem zweiten dotierten Bereich (D_12) des Typs eins vorgesehen ist.

2. Halbleitervorrichtung (200, 300) gemäß Anspruch 1, welche so ausgelegt ist, dass kein Silizid auf mindestens einem Teil der Wanne (W_1) des Typs eins angrenzend an den ersten dotierten Bereich (D_21) des Typs zwei und mindestens einem Teil des ersten dotierten Bereichs (D_21) des Typs zwei angrenzend an die Wanne (W_1) des Typs eins vorgesehen ist.

3. Halbleitervorrichtung (200, 300) gemäß Anspruch 1, wobei der Typ eins ein N-Typ ist und der Typ zwei ein P-Typ ist.

4. Halbleitervorrichtung (200, 300) gemäß Anspruch 1, wobei der Typ eins ein P-Typ ist und der Typ zwei ein N-Typ ist.

5. Halbleitervorrichtung (200, 300) gemäß Anspruch 1, welche so ausgelegt ist, dass kein Silizid auf mindestens einem Teil der Wanne (W_1) des Typs eins angrenzend an den dritten dotierten Bereich (D_13) des Typs eins und mindestens einem Teil des dritten dotierten Bereichs (D_13) des Typs eins angrenzend an die Wanne (W_1) des Typs eins vorgesehen ist.

## Revendications

1. Dispositif semi-conducteur (200, 300) appliqué en tant que dispositif ESD comprenant :
un substrat (S), qui comprend :
- un puits (W_1) de type un ;
- une première région dopée (D_21) de type deux, prévue dans le puits (W_1) de type un ;
- un puits (W_2) de type deux, adjacent au puits (W_1) de type un ;
- une première région dopée (D 11) de type un, dopée dans le puits (W_2) de type deux ;
- une troisième région dopée (D_13) de type un, dopée dans le puits (W_1) de type un, ne touchant pas physiquement la première région dopée (D_21) de type deux ; et
- une troisième région dopée (D_23) de type deux, dopée dans le puits (W_2) de type deux, touchant physiquement la première région dopée (D_11) de type un,
de sorte que le substrat (S) ne comprenne pas de matériau isolant prévu dans un chemin de courant (Cp) formé par la première région dopée (D_21) de type deux, le puits (W_1) de type un, le puits (W_2) de type deux et la première région dopée (D_11) de type un, et
comprenant en outre :
- un premier matériau conducteur (CM_1), prévu sur le puits (W_1) de type un et le puits (W_2) de type deux mais pas sur la première région dopée (D_11) de type un et la première région dopée (D_21) de type deux ;
- une deuxième couche conductrice (CM_2), prévue sur le puits (W_2) de type deux mais pas sur la première région dopée (D_11) de type un ;
- une deuxième région dopée (D_12) de type un, prévue dans le puits (W_2) de type deux ; et
- une deuxième région dopée (D_22) de type deux, prévue dans le puits (W_2) de type deux ;
dans lequel :
- la deuxième région dopée (D_22) de type deux et la deuxième région dopée (D_12) de type un sont prévues entre la première région dopée (D_11) de type un et la première région dopée (D_21) de type deux ;
- dans lequel le premier matériau conducteur (CM_1) est prévu sur une région entre la première région dopée (D_21) de type deux et la deuxième région dopée (D_22) de type deux ; et
- dans lequel le deuxième matériau conducteur (CM_2) est prévu sur une région entre la première région dopée (D_11) de type un et la deuxième région dopée (D_12) de type un.

2. Dispositif semi-conducteur (200, 300) de la revendication 1, qui est configuré de sorte qu'aucun siliciure ne soit prévu sur au moins une partie du puits (W_1) de type un adjacente à la première région dopée (D_21) de type deux, et au moins une partie de la première région dopée (D_21) de type deux adjacente au puits (W_1) de type un.

3. Dispositif semi-conducteur (200, 300) de la revendication 1, dans lequel le type un est de type N et le type deux est de type P.

4. Dispositif semi-conducteur (200, 300) de la revendication 1, dans lequel le type un est de type P et le type deux est de type N.

5. Dispositif semi-conducteur (200, 300) de la revendication 1, qui est configuré de sorte qu'aucun siliciure ne soit prévu sur au moins une partie du puits (W_1) de type un adjacente à la troisième région dopée (D_13) de type un, et au moins une partie de la troisième région dopée (D_13) de type un adjacente au puits (W_1) de type un.
